# FASCICULE DE BREVET EUROPEEN

(11) **EP 2 575 162 B1**
(45) Date de publication et mention de la délivrance du brevet: **23.05.2018**
(21) Numéro de dépôt: 12185100.0
(22) Date de dépôt: 19.09.2012
(51) Int. Cl.: H01L 21/306, H01L 21/8238

(54) **Procédé de fabrication d'un dispositif semi-conducteur avec une étape de retrait sélective d'une couche de silicium germanium**
Herstellungsverfahren einer Halbleitervorrichtung mit einer selektiven Schwindungsphase einer Silizium-Germanium-Schicht
Method for manufacturing a semiconductor device with a step of selectively removing a layer of silicon-germanium

(30) Priorité: 28.09.2011 FR 1158674
(43) Date de publication de la demande: 03.04.2013
(73) Titulaire: COMMISSARIAT À L'ÉNERGIE ATOMIQUE ET AUX ÉNERGIES ALTERNATIVES, 75015 Paris (FR)
(72) Inventeur: Le Tiec, Yannick, 38920 CROLLES (FR); Grenouillet, Laurent, 38140 RIVES (FR); Posseme, Nicolas, 29660 CARANTEC (FR); Vinet, Maud, 38140 RIVES (FR)
(74) Mandataire: Brizio Delaporte, Allison

(56) Documents cités:
- US-A1- 2006 068 557
- US-B1- 7 132 322

## Description

La présente invention concerne un procédé de fabrication d'un dispositif semi-conducteur avec une étape de retrait sélective d'une couche de silicium-germanium.

L'invention trouvera son application pour la fabrication de circuits intégrés et plus précisément de transistors. Notamment, pour l'optimisation des transistors CMOS (Semi-conducteur à oxyde de métal complémentaire ou Complementary Metal Oxide Semiconductor en anglais) de dernière génération, il est intéressant de prévoir un canal en silicium-germanium (SiGe) pour la partie PMOS (Semi-conducteur à oxyde de métal à canal positif ou Positive Metal Oxide Semiconductor en anglais). Toutefois, cette couche n'a pas d'intérêt pour un transistor NMOS (Semi-conducteur à oxyde de métal à canal négatif ou Negative Metal Oxide Semi-conductor en anglais). La fabrication de ces deux types de transistor PMOS et NMOS, peut être associée. Un transistor PMOS est dans un premier temps réalisé sur une couche de silicium-germanium puis le NMOS est préparé. Pour cela, le PMOS est masqué par une couche de résine de sorte à être protégé. Puis, il faut éliminer localement le silicium-germanium, à travers le masque de résine dans les zones destinées à recevoir un NMOS. Ce retrait du silicium-germanium doit être sélectif vis-à-vis des couches inférieures et de la résine.

On connaît pour cela de la gravure sèche au plasma. Malgré une sélectivité intéressante, le coût de cette technologie ne permet pas son utilisation à grande échelle.

Un traitement à base d'acide chlorhydrique gazeux (HCl) peut également être réalisé dans un réacteur. Cette technique n'est pas applicable à tous les transistors car la sélectivité varie grandement en fonction du pourcentage de germanium dans la couche de silicium-germanium à éliminer.

Des essais de gravure par voie humide ont été faits avec des solutions d'acide fluorhydrique (HF), de peroxyde d'hydrogène (H₂O₂) et d'acide acétique (CH₃COOH).

La gravure par voie humide n'est pas satisfaisante pour éliminer une couche de silicium-germanium, notamment en présence d'un masque de résine.

En effet, il s'est avéré que ce type de solution attaque une partie de la résine. Les flancs des motifs formés dans la résine sont notamment endommagés. La dimension des motifs est par conséquent peu maitrisée.

US 2006/068557 A1 divulgue un procédé de retrait d'une couche de silicium-germanium par exposition à une solution de gravure comprenant de l'acide hydrofluorique, du peroxyde d'hydrogène, et de l'acide acétique.

US 7132322 B1 divulgue un procédé de retrait d'une couche de silicium-germanium par exposition à une solution de gravure comprenant du peroxyde d'hydrogène, et de l'ammoniaque. Il existe donc le besoin de proposer un procédé pour éliminer une couche de silicium-germanium par voie humide et préférentiellement avec une sélectivité satisfaisante et sans endommager significativement un masque de résine.

A cet effet, la présente invention concerne un procédé de fabrication d'un dispositif semi conducteur par gravure chimique par voie humide, le dispositif comprenant au moins une couche de silicium (Si) et au moins une couche de silicium-germanium (SiGe) et au moins une couche de résine photosensible formant un masque recouvrant en partie la couche de silicium germanium (SiGe) et laissant libre la couche de silicium germanium en certaines zones caractérisé en ce qu'il comprend une étape de retrait de la couche de silicium-germanium (SiGe) au niveau desdites zones par exposition à une solution de gravure. La solution de gravure ayant un pH compris entre 3 et 6, est formée par une étape de fabrication à partir d'acide hydrofluorique (HF), de peroxyde d'hydrogène (H₂O₂), d'acide acétique (CH₃COOH) et d'ammoniaque (NH₄OH).

La combinaison de ces quatre composants dans la solution de gravure permet d'obtenir une étape de retrait préférentiellement sélective de la couche de silicium germanium. Le pH de la solution de gravure est étudié à la fois pour être compatible avec un masque de résine et à la fois pour permettre un retrait sélectif de la couche de silicium germanium. En effet, pour un homme de l'art ces objectifs semblent, a priori, opposés ; le pH pour ne pas endommager une résine, se situe avantageusement aux alentours de 3 à 6 alors que pour obtenir un retrait sélectif, la quantité d'espèces gravantes doit être maximale soit autour d'un pH de 1 à 2.

Selon l'invention, l'ajout d'ammoniaque (NH₄OH) à une solution contenant de l'acide hydrofluorique (HF) n'est habituellement pas envisagé puisque ce mélange entraine facilement la formation d'un sel de fluorure d'ammonium (NH₄F). La présence de ce sel entraine une défectivité sur la plaque de semi-conducteur, mais aussi des endommagements dans l'équipement en bloquant des conduits...

De plus, le mélange d'acide-base dans une telle solution de gravure génère couramment une forte exothermicité qui crée des problèmes de non uniformité de la gravure. En outre, plus une solution de gravure comporte de composés, plus les problèmes liés à l'uniformité de la gravure sont amplifiés.

Selon l'invention ces inconvénients sont au moins en partie levés par le présent procédé et sa solution de gravure.

Préférentiellement, la solution de gravure selon l'invention est diluée entre 5 et 500 fois. Cette dilution apporte de nombreux avantages dont un contrôle de la vitesse de gravure et une meilleure gravure. Le facteur de dilution est calculé par rapport au volume total de la solution de gravure avant dilution.

Le procédé selon l'invention permet un retrait des zones de silicium-germanium avec une très bonne sélectivité vis-à-vis des autres couches du transistor et sans endommager, ou peu, le masque de résine.

Selon une possibilité préférée, le procédé comprend au moins une étape de pré traitement et/ou une étape de post traitement respectivement avant et après l'étape de retrait.

Il est très avantageux de prévoir au moins une étape préliminaire de traitement, étape de pré traitement, facilitant ensuite le démarrage de l'étape de retrait. De même, l'étape de post traitement améliore avantageusement l'état de surface de la couche située sous les zones de retrait en retirant des éventuels contaminants, plus particulièrement de l'oxyde de silicium dans le cas d'un retrait total de la couche de silicium-germanium sur une zone, ou d'oxyde de silicium-germanium dans le cas d'un retrait partiel. Cette étape post traitement facilite les étapes suivantes éventuelles de retrait de couches et/ou de croissance.

Préférentiellement, les solutions utilisées pour l'étape de pré traitement et l'étape de post traitement sont fabriquées par mélange d'acide fluorhydrique (HF) et d'ammoniaque (NH₄OH).

Ce procédé de préparation amène à une solution tamponnée ayant un pH conforme à une utilisation avec un masque de résine, soit de 3 à 6 et avantageusement à une sélectivité envers le silicium-germanium.

Suivant des variantes préférées cumulatives ou alternatives de l'invention, le procédé est tel que :
- le pH de la solution de gravure est préférentiellement 3.5 et 4,
- la fabrication de la solution de gravure est réalisée à partir d'acide hydrofluorique (HF), de peroxyde d'hydrogène (H₂O₂), d'acide acétique (CH₃COOH) et d'ammoniaque (NH₄OH) dans des ratios respectifs de 1/2/3/4,
- la solution de gravure est diluée dans de l'eau déionisée entre 5 et 500 fois,
- la durée de l'exposition à la solution de gravure est comprise entre 20 secondes à 600 secondes,
- la durée de l'exposition à la solution de gravure est comprise entre 30 secondes à 120 secondes,
- il comprend avant l'étape de retrait une étape de prétraitement comprenant une exposition au moins desdites zones de la couche de silicium-germanium (SiGe) à une solution de prétraitement,
- il comprend une étape de fabrication d'une solution de prétraitement à partir d'acide hydrofluorique (HF) et d'ammoniaque (NH₄OH), préférentiellement dans un ratio NH4F/HF de 2/1 à 6/1,
- la durée de l'exposition à la solution de prétraitement est comprise entre 20 secondes et 300 secondes,
- la durée de l'exposition à la solution de pré traitement est comprise entre 30 secondes et 120 secondes,
- il comprend après l'étape de retrait une étape de post traitement par exposition au moins desdites zones de la couche de silicium-germanium (SiGe) à une solution de post-traitement,
- il comprend une étape de fabrication d'une solution de post-traitement à partir d'acide hydrofluorique (HF) et d'ammoniaque (NH₄OH), préférentiellement dans un ratio NH4F/HF de 2/1 à 6/1,
- la durée de l'exposition à la solution de post-traitement est comprise entre 10 secondes et 180 secondes,
- la durée de l'exposition à la solution de post traitement est comprise entre 20 secondes à 60 secondes,
- la couche de silicium-germanium (SiGe) contient un pourcentage de germanium allant de 5 à 60%,
- la couche de silicium-germanium (SiGe) forme un canal d'un transistor,
- l'étape de retrait de la couche de silicium-germanium (SiGe) est opérée de sorte à complètement retirer ladite couche de silicium-germanium (SiGe) sur lesdites zones, la couche de silicium (Si) étant mise à nu dans ces zones,

Le dispositif semi conducteur fabriqué par le présent procédé comprend au moins un transistor.

Les dessins ci-joints sont donnés à titre d'exemple et ne sont pas limitatifs de l'invention. Ils représentent seulement un mode de réalisation de l'invention et permettront de la comprendre aisément.

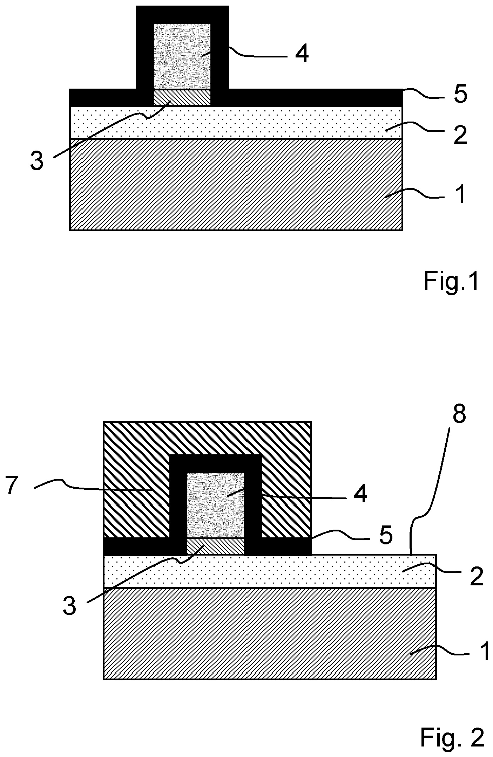

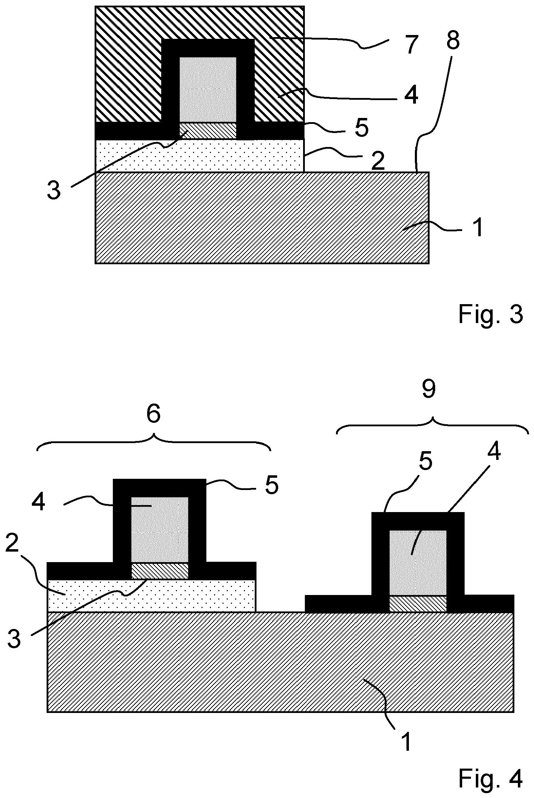

Les figures 1 à 4 représentent les différentes étapes de fabrication d'un CMOS comprenant au moins un transistor PMOS et au moins un transistor NMOS.
La figure 1 illustre un transistor PMOS 6 sur une couche de Silicium-Germanium 2.
La figure 2 illustre la protection du transistors PMOS 6 de la figure 1 par une couche de résine 7 pour la fabrication d'au moins un transistor NMOS 9. L'espaceur 5 et la résine 7 ayant été retirée sur les zones 8 où va être retirée la couche de silicium germanium 2 en vue de la formation du transistor NMOS 9.
La figure 3 illustre un transistors PMOS 6 où la couche de silicium germanium 2 a été retirée sur les zones 8 destinées à recevoir un transistor NMOS 9.
La figure 4 illustre un transistor PMOS 6 et un transistor NMOS 9 formés sur un même substrat 1.

Le dispositif comprend préférentiellement une plaque de substrat en silicium 1 ou silicium sur isolant (Silicium On Insulator en anglais - SOI).

Pour former un transistor PMOS 6, une couche de silicium germanium 2 est déposée sur le substrat en silicium 1. Le silicium-germanium 2 forme préférentiellement le canal du transistor PMOS 6.

Le transistor PMOS 6 comprend une grille 4, par exemple en poly silicium ou en métal, entourée de par et d'autres d'espaceurs 5, par exemple en oxyde de silicium ou en nitrure de silicium. Entre la grille 4 et la couche de silicium-germanium 2, se trouve une couche d'oxyde de silicium 3 ou un matériau à forte permittivité appelé «high k» comme par exemple HfO2, HfSiO, HfZr02, Al2O3.

Une fois, le (ou les) transistor PMOS 6 formé sur la couche de silicium-germanium 2, une couche de résine 7 photosensible, est disposée pour recouvrir totalement le transistor PMOS. La résine 2 est ensuite retirée au niveau des zones 8 entre les transistors PMOS 6. La couche de silicium-germanium 2 au niveau des zones 8 est mise à nu de sorte à permettre son retrait partiel ou total.

C'est dans ces zones 8 que le transistor NMOS 9 va être formé. Pour la formation d'un transistor NMOS 9, le retrait total de la couche de silicium-germanium 2 au niveau des zones 8 est préféré.

Selon l'invention, une solution de gravure est utilisée pour retirer la couche de silicium-germanium 2. Préférentiellement, avant le retrait de cette couche de silicium-germanium 2, une solution de pré traitement peut être appliquée. Préférentiellement, après le retrait de cette couche de silicium-germanium 2, une solution de post traitement peut être appliquée.

Le transistor NMOS 9 est formé sur un substrat en silicium 1 ou silicium sur isolant (Silicium On Insulator en anglais - SOI) et comprend une grille 4, par exemple en poly silicium ou en métal, entourée de par et d'autres d'espaceurs 5, par exemple en oxyde de silicium ou en nitrure de silicium. Entre la grille 4 et la couche de silicium-germanium 2, se trouve une couche d'oxyde de silicium 3 ou un matériau à forte permittivité appelé «high k» comme par exemple HfO2, HfSiO, HfZr02, Al2O3..

On entend par « sur » que les couches sont directement en contact mais aussi que la couche recouvre, avec éventuellement une couche intermédiaire.

Le retrait en au moins certaines zones 8 de la couche de silicium-germanium 2 dans un transistor doit présenter une sélectivité importante. L'évolution de la microélectronique tend notamment à réduire les dimensions des noeuds entre les transistors, les recherches actuelles visent à obtenir des noeuds inférieurs à 30 nanomètres. De plus, le substrat 1 en SOI se généralise et dans ce cas là l'épaisseur supérieure de silicium est critique, la gravure de la couche de silicium germanium 2 doit être hautement sélective pour ne pas graver le silicium du substrat 1. Il est alors essentiel que la netteté du retrait soit maximale sans endommager ou très faiblement la résine 7.

Selon l'invention la solution de gravure est préparée en mélangeant de l'acide fluorhydrique (HF), du peroxyde d'hydrogène (H₂O₂), de l'acide acétique (CH₃COOH) et de l'ammoniaque (NH₄OH).

Préférentiellement, la solution de gravure possède un pH supérieur à 3 et avantageusement inférieur à 6, avantageusement entre 3,5 et 4. Dans cette gamme de pH, il a pu être constaté que le masque de résine 7 n'est pas endommagé par la solution de gravure et que la sélectivité de gravure de la couche de silicium germanium 2 est satisfaisante, notamment vis-à-vis du substrat en silicium 1. La résine 7 mise en oeuvre selon l'invention est une résine photosensitive, par exemple en polymère de type PolyHydroStryréne (PHS). Avantageusement, la résine 7 est déposée en une couche d'une épaisseur de 100 à 200nm.

Les proportions des quatre composants initiaux de la solution de gravure sont étudiées. Préférentiellement, la solution de gravure est préparée avec un rapport entre les quatre composants initiaux étant 1/2/3/4 respectivement de HF/H₂O₂/CH₃COOH/NH₄OH. L'ammoniaque (NH₄OH) en quantité plus importante permet de neutraliser les acides à savoir l'acide fluorhydrique (HF) et l'acide acétique (CH₃COOH). Il y a une augmentation de pH. La solution ainsi formée est une solution tamponnée, elle a la propriété de conserver son pH stable sur une certaine gamme de dilution.

Préférentiellement, l'acide hydrofluorique (HF) utilisé est à 49% en pourcentage massique, l'ammoniaque comprend 28% de NH₄OH en pourcentage massique et l'acide acétique est pur à 100%.

Il est préféré de diluer la solution de gravure. La dilution est avantageusement réalisée par de l'eau déionisée. La dilution de la solution est préférentiellement comprise entre 5 et 500 fois, préférentiellement de 20 à 100 fois.

La dilution de la solution contribue à atténuer l'exothermicité lors du mélange des quatre composants (confère exemples 3 et 4). La diminution de la température permet notamment de contrôler la vitesse de gravure et d'améliorer l'homogénéité de la gravure sur l'ensemble de la plaque en limitant les différences entre les zones de bordures et les zones centrales.

La faible exothermicité de la solution de gravure lors de sa fabrication permet une utilisation quasi simultanée. Il n'est pas nécessaire de prévoir un délai d'attente entre la préparation de la solution de gravure et son utilisation.

Selon l'invention, la solution de gravure peut être fabriquée de manière dynamique en injectant directement les quatre composants et l'eau déionisée simultanément et de manière indépendante non mélangé ou bien de manière anticipée où le mélange des quatre composants est préparé au préalable puis injecté.

Le procédé selon l'invention permet une sélectivité de l'étape de retrait de la couche de silicium germanium 2 vis-à-vis de la couche de silicium 1 comprise entre 4/1 et 50/1 pour des couches de silicium germanium allant de 5 à 60% de germanium, préférentiellement de 10 à 60%.

La sélectivité s'entend du rapport des épaisseurs relevées des différentes couches par la solution de gravure ou bien le rapport des vitesses de gravure des différents matériaux par la solution de gravure.

### Exemple 1 - Préparation d'une solution de gravure non diluée:

Une solution de gravure est préparée suivant les informations ci-dessous sans dilution : HF/H2O2/CH3COOH/NH4OH dans des rapports de 1/2/3/4 sans addition d'eau déionisée pour la dilution.

| | | | |
|---|---|---|---|
| **V (H20) cc** | **V(H202) cc** | **V (dilution) cc** | |
| 0 | 20 | 20 | |
| **%HF** | **V(HF) cc** | **d(HF)** | **n(HF) mol** |
| 49 | 10 | 1,19 | 0,2916 |
| **% NH4OH** | **V(NH4OH) cc** | **d(NH4OH)** | **n(NH4OH) mol** |
| 28 | 40 | 0,895 | 0,2860 |
| **% CH3COOH** | **V(CH3COOH) cc** | **d(CH3COOH)** | **n(CH3COOH) mol** |
| 100 | 30 | 1,045 | 0,5221 |

Par simulation, les concentrations théoriques en moles/litre des différentes espèces chimiques présentes dans la solution de gravure sont les suivantes.

| **pH** | **[H3O+]** | **[HF]** | **[F-]** | **[HF2-]** | **[NH4+]** | **[CH3COO-]** | **[OH-]** |
|---|---|---|---|---|---|---|---|
| 4,09 | 8.13E-05 | 1.45E-01 | 1.24E+00 | 7.11E-01 | 2.86E+00 | 9.20E-01 | 1.2303E-10 |

### Exemple 2 - Préparation d'une solution de gravure diluée:

Une solution de gravure est préparée suivant les informations ci-dessous avec dilution : HF/H2O2/CH3COOH/NH4OH dans des rapports de 1/2/3/4 avec une dilution dans 400cc d'eau déionisée. La dilution est de 5 fois pour un ratio pouvant être défini comme 1/2/3/4/40.

| | | | |
|---|---|---|---|
| **V(H20)cc** | **V(H202)cc** | **V(dilution) cc** | |
| 400 | 20 | 420 | |
| **%HF** | **V(HF)cc** | **d(HF)** | **n(HF)mol** |
| 49 | 10 | 1,19 | 0,2916 |
| **% NH4OH** | **V(NH4OH) cc** | **d(NH4OH)** | **n(NH4OH) mol** |
| 28 | 40 | 0,895 | 0,2860 |
| **% CH3COOH** | **V(CH3COOH) cc** | **d(CH3COOH)** | **n(CH3COOH) mol** |
| 100 | 30 | 1,045 | 0,5221 |

Le pH et les concentrations théoriques des différentes espèces présentes dans la solution de gravure sont présentées dans le tableau ci-dessous.

| **pH** | **[H3O+]** | **[HF]** | **[F-]** | **[HF2-]** | **[NH4+]** | **[CH3COO-]** | **[OH-]** |
|---|---|---|---|---|---|---|---|
| 3,95 | 1,12E-04 | 5,69E-02 | 3,51E-01 | 7,90E-02 | 5,72E-01 | 1,40E-01 | 8,9125E-11 |

Grâce au procédé de fabrication de la solution de gravure selon l'invention, la solution de gravure est une solution tamponnée. Les dilutions, permettent d'adapter les vitesses de gravure sans modification notable du pH de la solution, celle-ci étant tamponnée.

### Exemple 3 - Etape de retrait :

Une solution de gravure est préparée suivant les quantités ci-dessous. Les concentrations des différents composants sont proches de celles de l'exemple 1.

| v(HF) | V(H2O2) | v(CH3COOH) | v(NH4OH) | v(DI) | vTotal | pH |
|---|---|---|---|---|---|---|
| 10 | 20 | 30 | 40 | 100 | 200 | 4.03 |

La solution de gravure ainsi préparée est utilisée sur :
- une couche de 28nm de silicium-germanium (SiGe) à 30%,
- une couche de 74nm de silicium-germanium (SiGe) à 20%,
- une couche de 45nm de silicium (Si).

| Temps d'exposition | T°C | Epaisseur retirée |
|---|---|---|
| 2 min | 50 | Toutes les couches sont retirées |

La solution de gravure présente une exothermicité importante. La vitesse de gravure étant trop élevée la sélectivité de la solution ne peut pas être calculée.

Les mesures d'épaisseurs des couches sont réalisées par ellipsométrie.

### Exemple 4 - Etape de retrait :

Une solution de gravure est préparée suivant les quantités ci-dessous. Les concentrations des différents composants sont proches de celles de l'exemple

| v(HF) | V(H2O2) | v(CH3COOH) | v(NH4OH) | v(DI) | vTotal | pH |
|---|---|---|---|---|---|---|
| 10 | 20 | 30 | 40 | 400 | 500 | 3.95 |

La solution de gravure ainsi préparée est utilisée sur :
- une couche de 28nm de silicium-germanium (SiGe) à 30%,
- une couche de 74nm de silicium-germanium (SiGe) à 20%,
- une couche de 45nm de silicium (Si).

| Temps d'exposition | T°C | Epaisseur retirée |
|---|---|---|
| 1 min | 35 | 2.9nm de Si pour 12nm de SiGe à 20% |

On arrive avec cette solution à graver sélectivement la couche de silicium-germanium (SiGe) à 20% avec une sélectivité de l'ordre de 1/4 vis-à-vis du silicium (Si).

En diminuant également la durée de l'exposition, on contrôle l'épaisseur retirée des couches de silicium et silicium-germanium.

Sans être liée à une théorie, cette sélectivité pourrait s'expliquer par le fait que la solution de gravure contient des composants formant des espèces oxydantes à savoir le peroxyde d'hydrogène (H2O2) et l'acide acétique (CH₃COOH) qui forment de l'acide per acétique (CH3CO3H) à fort pouvoir oxydant.

Une fois les quatre composants mélangés et à l'équilibre de la réaction, on retrouve dans la solution de gravure les espèces suivantes : ion hydronium (H3O+), acide hydrofluorique (HF), ion fluorure (F-), ion hydrogène difluoride (HF2-), ion ammonium (NH4+), ion hydroxyde (OH-).

La solution de gravure contient également des composants formant des espèces gravantes à savoir l'acide fluorhydrique (HF) et l'ammoniaque (NH₄OH) qui forment des espèces présentant un haut pouvoir gravant.

L'ajout d'ammoniaque (NH₄OH) augmente le pH de la solution de gravure et l'éloigne d'une gravure efficace mais l'ammoniaque (NH₄OH) réagit notamment avec l'acide fluorhydrique (HF) pour former du fluorure d'ammonium (NH4F) sous forme ion ammonium/ ion fluorure (NH4+/F-) qui contribue à la gravure du silicium germanium par formation d'hydrogène difluoride (HF2-) entre l'acide fluorhydrique (HF) et l'ion fluorure (F-).

Lors de l'étape de retrait, les phénomènes d'oxydation et de gravure se succèdent de manière répétitive.

L'étape de retrait a une durée comprise entre 20 et 600 secondes en fonction de la vitesse de gravure de la solution et de l'épaisseur de la couche que l'on souhaite retirer. Préférentiellement, elle dure de 30 à 120 secondes, avantageusement de l'ordre de 60 secondes.

Selon un mode de réalisation préféré de l'invention, le procédé de fabrication du dispositif semi-conducteur comprend également au moins une étape de pré traitement. Cette étape de pré traitement est effectuée avant l'étape de retrait. Elle consiste à exposer les zones 8 de la couche de silicium-germanium 2 (SiGe) à retirer à une solution de prétraitement. Lors de cette étape de prétraitement, la couche de résine 7 est préférentiellement déjà en place. La solution de prétraitement est donc avantageusement compatible avec la couche de résine 7. Cette étape de prétraitement permet avantageusement de supprimer les contaminants éventuels à la surface de la couche de silicium germanium 2 à retirer. Parmi les contaminants, des traces d'oxydes de silicium sont retirées par la solution de prétraitement. En effet, il est préféré que la couche de silicium-germanium 2 (SiGe) ne soit pas contaminée ni oxydée avant l'étape de retrait. A défaut, lors de l'étape de retrait, la gravure ne débute pas simultanément sur toute la surface des zones à retirer, on obtient alors un retrait non homogène.

La durée de l'exposition de l'étape de prétraitement est de 20 à 300 secondes préférentiellement de 30 à 120 secondes, avantageusement de l'ordre de 40 secondes.

La solution de prétraitement a un pH préférentiellement compris entre 3 et 5, avantageusement de l'ordre de 3. Elle contient avantageusement de l'acide fluorhydrique (HF). La solution de prétraitement possède avantageusement un ratio de NH4F / HF allant de 2/1 à 500/1, préférentiellement de 2/1 à 30/1, encore préférentiellement de 2/1 à 6/1.

A titre préféré, la solution de prétraitement est formée à partir d'acide fluorhydrique (HF) et d'ammoniaque (NH₄OH). Le solvant est typiquement de l'eau déionisée. La réaction est quasiment totale entre ces deux espèces pour former un sel de fluorure d'ammonium (NH4F). Si l'acide fluorhydrique (HF) est en excès, la réaction est limitée par la quantité d'ammoniaque (NH₄OH) initialement introduite de sorte que la solution finale à l'équilibre correspond à un mélange d'acide fluorhydrique (HF) et fluorure d'ammonium (NH4F). La solution est tamponnée. Ce procédé de fabrication permet d'obtenir une solution avec un pH compatible avec un masque de résine ainsi que de permettre de grandes dilutions en conservant un pH convenable. La solution est diluée de 5 et 100 fois préférentiellement environ 50 fois. Le sel de fluorure d'ammonium (NH4F) se trouve avantageusement sous une forme dissoute (NH4+/F-).

Selon un mode de réalisation cumulatif ou alternatif du précédent, le procédé comprend au moins une étape de post-traitement. Cette étape de post traitement est effectuée après l'étape de retrait. Elle consiste à exposer les zones 8 de la couche de silicium-germanium 2 (SiGe) qui ont été totalement ou partiellement retirées lors de l'étape de retrait à une solution de post traitement. Cette étape contribue à supprimer les contaminants éventuels laissés à la surface desdites zones à l'issue de l'étape de retrait. Parmi ces contaminants, on retrouve des oxydes de silicium, silicium-germanium et/ou des composants restants de la solution de gravure. Cette étape consiste à un nettoyage desdites zones 8 de sortes à permettre une nouvelle étape de retrait, telle que décrite ci-dessus, ou bien une étape de croissance de couche.

La durée de l'exposition de l'étape de post-traitement est comprise entre 10 et 180 secondes préférentiellement de 20 à 60 secondes et avantageusement de l'ordre de 20 secondes.

La solution de post traitement est préférentiellement identique à la solution de prétraitement décrite ci-dessus.

Selon une possibilité avantageuse, le procédé comprend dans l'ordre une étape de prétraitement, une étape de retrait et une étape de post-traitement. Il peut être avantageux de prévoir plusieurs de ces étapes. A titre d'exemple, le procédé comprend dans l'ordre une étape de prétraitement, une étape de retrait, une étape de post-traitement, une étape de retrait et une étape de post-traitement. Le nombre d'étapes de retrait et donc d'étapes de pré et post-traitement dépend de l'épaisseur et du nombre de couches à retirer.

Dans un exemple préféré, le procédé comprend une étape de prétraitement d'une durée de l'ordre de 30 à 90 secondes préférentiellement de l'ordre de 60 secondes, une étape de retrait d'une durée de l'ordre de 30 à 180 secondes préférentiellement de l'ordre de 60 à 120 secondes et une étape de post-traitement d'une durée de l'ordre de 20 à 90 secondes préférentiellement de l'ordre de 20 à 60 secondes.

### Exemple 5 - procédé de fabrication d'un dispositif semi-conducteur

Une solution de gravure est fabriquée selon l'exemple 2.

Une solution de prétraitement et une solution de post-traitement sont respectivement préparées en mélangeant 30 cc d'acide hydrofluorique (HF) à 48%, d=1.15g/cm3, 30 cc d'ammoniaque (NH₄OH) à 29% dans 1600cc d'eau déionisée. Le ratio de fluorure d'ammoniaque (NH4F)/ acide hydrofluorique (HF) est de 3/1 pour un pH de 3,48.

Les étapes de prétraitement, de retrait et de post traitement sont réalisées successivement avec des durées respectives de 60 secondes sur les échantillons suivants : soit du Silicium, soit des couches de silicium germanium à des concentrations différentes : 28nm SiGe 30% - 53nmSiGe 10% -75nm SiGe 20% - 40nm SiGe 40% - 26nm SiGe 50%.

| **Echantillons** | **Gravure** (nm) |
|---|---|
| 45nm Si | 0,9 |
| 53nm SiGe 10% | 1,2 |
| 75nm SiGe 20% | 2 |
| 28nm SiGe 30% | Tout (28) |
| 40nm SiGe 40% | Tout (40) |

Le retrait de la couche de silicium est de l'ordre de 0,9nm alors que le retrait de la couche de silicium-germanium à 10 % est de l'ordre de 1,2nm. Une couche de silicium-germanium à 30% est complètement retirée soit 28nm.

On obtient une sélectivité de l'ordre de 30/1 pour la couche de silicium germanium à 30%. La vitesse de gravure est de 120 Angstrom/minutes ou 12nmmin pour le silicium germanium à 30%.

En diluant d'avantage, la vitesse de gravure peut être diminuée si on souhaite ne pas retirer l'ensemble de la couche de silicium germanium. A défaut, le temps de gravure est réduit pour limiter le retrait.

### REFERENCES

- 1.: Substrat en silicium
- 2.: Silicium-germanium
- 3.: Oxyde de silicium
- 4.: Grille
- 5.: Espaceur
- 6.: Transistor PMOS
- 7.: Résine
- 8.: Zone de gravure
- 9.: Transistor NMOS

## Revendications

1. Procédé de fabrication d'un dispositif semi conducteur par gravure chimique par voie humide le dispositif comprenant au moins une couche de silicium (Si) et au moins une couche de silicium-germanium (SiGe) (2) et au moins une couche de résine (7) photosensible formant un masque recouvrant en partie la couche de silicium germanium (SiGe) (2) et laissant libre la couche de silicium germanium en certaines zones (8), le procédé comprenant une étape de fabrication d'une solution de gravure, ayant un pH compris entre 3 et 6, à partir d'acide hydrofluorique (HF), de peroxyde d'hydrogène (H₂O₂), d'acide acétique (CH₃COOH) et d'ammoniaque (NH₄OH) et une étape de retrait de la couche de silicium-germanium (SiGe) (2) au niveau desdites zones (8) par exposition à ladite solution de gravure.

2. Procédé selon la revendication précédente dans lequel le pH de la solution de gravure est compris entre 3,5 et 4.

3. Procédé selon l'une quelconques des revendications précédentes dans lequel la fabrication de la solution de gravure est réalisée à partir d'acide hydrofluorique (HF) à 49%, de peroxyde d'hydrogène (H₂O₂), d'acide acétique (CH₃COOH) à 100% et d'ammoniaque (NH₄OH) à 28% dans des ratios respectifs de 1/2/3/4 en volume.

4. Procédé selon l'une quelconques des revendications précédentes dans lequel au cours de l'étape de fabrication, la solution de gravure est diluée dans de l'eau déionisée entre 5 et 500 fois.

5. Procédé selon l'une quelconque des revendications précédentes dans lequel la durée de l'exposition à la solution de gravure est comprise entre 20 secondes à 600 secondes.

6. Procédé selon l'une quelconque des revendications précédentes dans lequel la durée de l'exposition à la solution de gravure est comprise entre 30 secondes à 120 secondes.

7. Procédé selon l'une quelconque des revendications précédentes comprenant avant l'étape de retrait une étape de prétraitement comprenant une étape de fabrication d'une solution de prétraitement à partir d'acide hydrofluorique (HF) à 48% et d'ammoniaque (NH₄OH) à 29% préférentiellement configuré pour obtenir un ratio en volume NH4F/HF de 2/1 à 6/1 et une exposition au moins desdites zones (8) de la couche de silicium-germanium (SiGe) (2) à une solution de prétraitement de sorte à faciliter le démarrage de l'étape de retrait.

8. Procédé selon la revendication précédente dans lequel la durée de l'exposition à la solution de prétraitement est comprise entre 20 secondes et 300 secondes.

9. Procédé selon l'une quelconque des deux revendications précédentes dans lequel la durée de l'exposition à la solution de pré traitement est comprise entre 30 secondes et 120 secondes.

10. Procédé selon l'une quelconque des revendications précédentes comprenant une étape de fabrication d'une solution de post-traitement à partir d'acide hydrofluorique (HF) à 48% et d'ammoniaque (NH₄OH) à 29% préférentiellement configuré pour obtenir un ratio en volume de NH4F/HF de 2/1 à 6/1 et comprend après l'étape de retrait une étape de post traitement par exposition au moins desdites zones (8) de la couche de silicium-germanium (SiGe) (2) à une solution de post-traitement de sorte à améliorer l'état de surface de la couche située sous les zones de retrait (8) en retirant d'éventuels contaminants.

11. Procédé selon la revendication précédente dans lequel la durée de l'exposition à la solution de post-traitement est comprise entre 10 secondes et 180 secondes.

12. Procédé selon l'une quelconque des deux revendications précédentes dans lequel la durée de l'exposition à la solution de post traitement est comprise entre 20 secondes à 60 secondes.

13. Procédé selon l'une quelconque des revendications précédentes dans lequel la couche de silicium-germanium (SiGe) contient un pourcentage de germanium allant de 5 à 60%.

14. Procédé selon l'une quelconque des revendications précédentes dans lequel la couche de silicium-germanium (SiGe) forme un canal d'un transistor.

15. Procédé selon l'une quelconque des revendications précédentes dans lequel l'étape de retrait de la couche de silicium-germanium (SiGe) (2) est opérée de sorte à complètement retirer ladite couche de silicium-germanium (SiGe) (2) sur lesdites zones (8), la couche de silicium (Si) (1) étant mise à nu dans ces zones (8).

## Patentansprüche

1. Verfahren zum Herstellen einer Halbleitervorrichtung durch chemisches Nassätzen, wobei die Vorrichtung zumindest eine Schicht aus Silicium (Si) und zumindest eine Schicht aus Silicium-Germanium (SiG2) (2) und zumindest eine lichtempfindliche Harzschicht (7) enthält, die eine die Schicht aus Silicium-Germanium (SiGe) (2) teilweise überdeckende und die Schicht aus Silicium-Germanium in bestimmen Bereichen (9) freilassende Maske bildet,
wobei das Verfahren einen Schritt des Herstellens einer Ätzlösung mit einem pH-Wert zwischen 3 und 6 ausgehend von Fluorwasserstoffsäure (HF), Wasserstoffperoxid (H₂O₂), Essigsäure (CH₃COOH) und Ammoniak (NH₄OH) umfasst sowie einen Schritt des Entfernens der Schicht aus Silicium-Germanium (SiGe) (2) in Höhe der genannten Bereiche (8), indem sie der Ätzlösung ausgesetzt wird.

2. Verfahren nach dem vorangehenden Anspruch, wobei der pH-Wert der Ätzlösung zwischen 3,5 und 4 beträgt.

3. Verfahren nach einem der vorangehenden Ansprüche, wobei das Herstellen der Ätzlösung ausgehend von 49 %-iger Fluorwasserstoffsäure (HF), Wasserstoffperoxid (H₂O₂), 100 %-iger Essigsäure (CH₃COOH) und 28 %-igem Ammoniak (NH₄OH) jeweils im Volumenverhältnis 1:2:3:4 erfolgt.

4. Verfahren nach einem der vorangehenden Ansprüche, wobei bei dem Schritt des Herstellens die Ätzlösung in entionisiertem Wasser 5- bis 500-mal verdünnt wird.

5. Verfahren nach einem der vorangehenden Ansprüche, wobei die Dauer des Aussetzens der Ätzlösung zwischen 20 Sekunden und 600 Sekunden beträgt.

6. Verfahren nach einem der vorangehenden Ansprüche, wobei die Dauer des Aussetzens der Ätzlösung zwischen 30 Sekunden und 120 Sekunden beträgt.

7. Verfahren nach einem der vorangehenden Ansprüche, umfassend vor dem Schritt des Entfernens einen Schritt der Vorbehandlung, umfassend einen Schritt des Herstellens einer Vorbehandlungslösung ausgehend von 48 %-iger Fluorwasserstoffsäure (HF) und 29 %-igem Ammoniak (NH₄OH), vorzugsweise derart, dass ein Volumenverhältnis NH₄F/HF von 2:1 bis 6:1 und ein Aussetzen zumindest der Bereiche (8) der Schicht aus Silicium-Germanium (SiGe) (2) einer Vorbehandlungslösung, so dass das Anlaufen des Schritts des Entfernens erleichtert wird.

8. Verfahren nach dem vorangehenden Anspruch, wobei die Dauer des Aussetzens der Vorbehandlungslösung zwischen 20 Sekunden und 300 Sekunden beträgt.

9. Verfahren nach einem der beiden vorangehenden Ansprüche, wobei die Dauer des Aussetzens der Vorbehandlungslösung zwischen 30 Sekunden und 120 Sekunden beträgt.

10. Verfahren nach einem der vorangehenden Ansprüche, umfassend einen Schritt des Herstellens einer Nachbehandlungslösung ausgehend von 48 %-iger Fluorwasserstoffsäure (HF) und 29 %-igem Ammoniak (NH₄OH), vorzugsweise derart, dass ein Volumenverhältnis NH₄F/HF von 2:1 bis 6:1 erhalten wird, sowie nach dem Schritt des Entfernens einen Nachbehandlungsschritt durch Aussetzen zumindest der Bereiche (8) der Schicht aus Silicium-Germanium (SiGe) (2) einer Nachbehandlungslösung, so dass der Oberflächenzustand der Schicht verbessert wird, die unter den Entfernungsbereichen (8) liegt, indem eventuell vorhandene Verunreinigungen entfernt werden.

11. Verfahren nach dem vorangehenden Anspruch, wobei die Dauer des Aussetzens der Nachbehandlungslösung zwischen 10 Sekunden und 180 Sekunden beträgt.

12. Verfahren nach einem der beiden vorangehenden Ansprüche, wobei die Dauer des Aussetzens der Nachbehandlungslösung zwischen 20 Sekunden und 60 Sekunden beträgt.

13. Verfahren nach einem der vorangehenden Ansprüche, wobei die Schicht aus Silicium-Germanium (SiGe) einen Prozentsatz an Germanium von 5 bis 60 % enthält.

14. Verfahren nach einem der vorangehenden Ansprüche, wobei die Schicht aus Silicium-Germanium (SiGe) einen Transistorkanal bildet.

15. Verfahren nach einem der vorangehenden Ansprüche, wobei der Schritt des Entfernens der Schicht aus Silicium-Germanium (SiGe) (2) so erfolgt, dass die Schicht aus Silicium-Germanium (SiGe) (2) an den Bereichen (8) vollständig entfernt wird, wobei die Schicht aus Silicium (Si) (1) in diesen Bereichen (8) freigelegt wird.

## Claims

1. Method for manufacturing a semiconductor device via wet chemical etching the device comprising at least one layer of silicon (Si) and at least one layer of silicon-germanium (SiGe) (2) and at least one layer of light-sensitive resin (7) forming a mask partly covering the layer of silicon germanium (SiGe) (2) and leaving free the layer of silicon germanium in certain zones (8), the method comprising a step of manufacturing an etching solution, having a pH between 3 and 6, from hydrofluoric acid (HF), hydrogen peroxide (H₂O₂), acetic acid (CH₃COOH) and ammonia solution (NH₄OH) and a step of removing the layer of silicon-germanium (SiGe) (2) in said zones (8) via exposure to said etching solution.

2. Method according to the previous claim, wherein the pH of the etching solution is between 3.5 and 4.

3. Method according to any one of the previous claims, wherein the manufacturing of the etching solution is carried out using hydrofluoric acid (HF) at 49%, hydrogen peroxide (H₂O₂), acetic acid (CH₃COOH) at 100% and ammonia solution (NH₄OH) at 28% in respective ratios of 1/2/3/4 by volume.

4. Method according to any one of the previous claims, wherein during the manufacturing step, the etching solution is diluted in deionised water between 5 and 500 times.

5. Method according to any one of the previous claims, wherein the duration of the exposure to the etching solution is between 20 seconds to 600 seconds.

6. Method according to any one of the previous claims, wherein the duration of the exposure to the etching solution is between 30 seconds to 120 seconds.

7. Method according to any one of the previous claims, comprising, before the step of removal, a step of pretreatment comprising a step of manufacturing a pretreatment solution from hydrofluoric acid (HF) at 48% and ammonia solution (NH₄OH) at 29%, preferably configured to obtain a ratio of NH4F/HF of 2/1 to 6/1 by volume and exposure of at least said zones (8) of the layer of silicon-germanium (SiGe) (2) to a pretreatment solution in such a way as to facilitate the beginning of the removal step.

8. Method according to the previous claim, wherein the duration of the exposure to the pretreatment solution is between 20 seconds and 300 seconds.

9. Method according to any one of the previous two claims, wherein the duration of the exposure to the pretreatment solution is between 30 seconds and 120 seconds.

10. Method according to any one of the previous claims, comprising a step of manufacturing a post-treatment solution from hydrofluoric acid (HF) at 48% and ammonia solution (NH₄OH) at 29%, preferably configured to obtain a ratio of NH4F/HF of 2/1 to 6/1 by volume and comprises, after the step of removal, a step of post-treatment via exposure of at least said zones (8) of the layer of silicon-germanium (SiGe) (2) to a post-treatment solution in order to improve the surface state of the layer located under the zones of removal (8) by eliminating possible contaminants.

11. Method according to the previous claim, wherein the duration of the exposure to the post-treatment solution is between 10 seconds and 180 seconds.

12. Method according to any one of the previous two claims, wherein the duration of the exposure to the post-treatment solution is between 20 seconds to 60 seconds.

13. Method according to any one of the previous claims, wherein the layer of silicon-germanium (SiGe) contains a percentage of germanium from 5 to 60%.

14. Method according to any one of the previous claims, wherein the layer of silicon-germanium (SiGe) forms a channel of a transistor.

15. Method according to any one of the previous claims, wherein the step of removal of the layer of silicon-germanium (SiGe) (2) is carried out in such a way as to completely remove said layer of silicon-germanium (SiGe) (2) in said zones (8), the layer of silicon (Si) (1) being exposed in these zones (8).
